# EUROPÄISCHE PATENTSCHRIFT

(11) **EP 1 242 829 B1**
(45) Veröffentlichungstag und Bekanntmachung des Hinweises auf die Patenterteilung: **19.11.2003**
(21) Anmeldenummer: 00990592.8
(22) Anmeldetag: 29.12.2000
(51) Int. Cl.: G01R 29/10

(54) **MOBILE ANORDNUNG UND VERFAHREN ZUR GROSSFLÄCHIGEN UND GENAUEN CHARAKTERISIERUNG VON STRAHLUNGSFELDERN IM AUSSENBEREICH**
MOBILE SYSTEM AND METHOD FOR CHARACTERIZING RADIATION FIELDS OUTDOORS IN AN EXTENSIVE AND PRECISE MANNER
SYSTEME MOBILE ET PROCEDE POUR CARACTERISER DE MANIERE ETENDUE ET PRECISE DES CHAMPS DE RAYONNEMENT A L'EXTERIEUR

(30) Priorität: 30.12.1999 DE 19963794; 04.09.2000 DE 10043461
(43) Veröffentlichungstag der Anmeldung: 25.09.2002
(73) Patentinhaber: EADS Astrium GmbH, 81663 München (DE)
(72) Erfinder: Fritzel, Torsten, 85521 Ottobrunn (DE)
(74) Vertreter: Ulrich, Thomas
(86) Internationale Anmeldenummer: DE0004681
(87) Internationale Veröffentlichungsnummer: WO01050145

(56) Entgegenhaltungen:
- GB-A- 1 303 621
- HENSS: "hubschrauber-messung" N.T.Z. NACHRICHTENTECHNISCHE ZEITSCHRIFT, Bd. 40, Nr. 4, April 1987 (1987-04), Seiten 258-261, XP002168218 berlin,de
- STEHLE ET AL.: "reledop: a full-scale antenna pattern measurement" IEEE TRANS. ON BROADCASTING, Bd. 34, Nr. 2, Juni 1988 (1988-06), Seiten 210-220, XP000054225 new-york,us
- "measuring helicopter-antenna" NTIS, Bd. 73d092, Mai 1987 (1987-05), Seite 0423 XP002168220 springfield,va,us

## Beschreibung

Die vorliegende Erfindung bezieht sich auf eine Anordnung und ein Verfahren zur hochgenauen Charakterisierung von Strahlungsfeldern, wie durch die unabhängigen Patentansprüche beschrieben.

Die Charakterisierung von Strahlungsfeldern ist in vielen Bereichen unverzichtbar, wie z.B. in der Antennennahfeldmeßtechnik. Die Nahfeldmeßtechnik wird bevorzugt eingesetzt bei Antennen im Frequenzbereich von ca. 0,5 bis max. 20 GHz. Bei dieser Meßmethode wird das unmittelbare elektromagnetische Nahfeld einer Antenne vermessen und mit einer Nahfeld (NF) zu Fernfeld (FF) Transformation in das Fernfeld mittels Fast Fourier Transformation (FFT) umgerechnet. Der Vorteil der Vermessung des Nahfeldes einer Antenne liegt in den kompakten Abmessungen der notwendigen Antennenmeßanlagen, die bisher fast ausschließlich in stationären Meßkammern integriert wurden.

Im Gegensatz zu Nahfeldmeßanlagen gibt es noch Fernfeldmeßanlagen, diese sind aufgrund ihrer Abmessungen zwar Außenanlagen, sind aber stets stationäre Einrichtungen, wobei diese durch Reflexionen aus der Umgebung, durch Geländeformationen, Gebäude, etc. in wesentlich stärkerem Umfang fehlerbehaftet sind.

Ein weiterer Vorteil der Nahfeldmeßtechnik ist, daß infolge einer Nahfeldaufnahme sämtliche Fernfeldschnitte berechnet werden können, während die einmal gemessenen Fernfeldschnitte fix sind und die Antenne für weitere Fernfeldschnitte zu einen späteren Zeitpunkt, wieder neu vermessen werden muß.

Das Nahfeld wird entsprechend dem Abtasttheorem in < λ/2 Abständen abgescannt, wobei die gesamte von der Antenne abgegebene elektromagnetische Strahlung bis auf ca. -45db detektiert werden muß, da die Gesamtheit dieser Meßpunkte Einfluß auf jeden einzelnen errechneten Femfeldpunkt hat.

Zur Vermessung von omnidirektionalen Antennen werden in der Regel sphärische Scanner eingesetzt, die das Nahfeld der zu vermessenden Antenne auf einer Kugeloberfläche abscannen. Bei Richtantennen kann auf die aufwendigen sphärischen Scanner verzichtet werden, solange sichergestellt ist, daß sämtliche Strahlungsanteile bis ca. -45db auf einer Zylinderoberfläche oder auf einer planaren Fläche detektiert werden können. Da z.B. in der Telekommunikation hauptsächlich Richtantennen (Parabolantennen) verwendet werden, fällt die Wahl in diesem Bereich meistens auf zylindrische Nahfeldmeßanlagen oder Planaranlagen.

Da bei der NF zu FF Transformation neben den Amplitudenwerten der einzelnen Meßpunkte auch ganz wesentlich die Phaseninformation mit eingeht, sollte ein Scanner, je nach Typ, möglichst ideal entweder eine Kugeloberfläche, einen Zylinder oder eine planare Fläche mit einer Meßsonde abscannen können, da die NF zu FF Transformation mathematisch von diesem Idealfall ausgeht. Fehlerbeiträge durch den Scanner einer Nahfeldmeßanlage sollten eine Abweichung von λ/50 von der Idealkontur nicht übersteigen

Somit beträgt eine zu fordernde Scannergenauigkeit 3,0 mm, bei f=2,0 GHz und einer Phasengenauigkeit von λ/50. Soweit Bodenstationsantennen mit z.B. 14m Antennendurchmesser mit einer Planarmeßanlage vermessen werden sollen, bedeutet dies, daß diese Genauigkeit auf einer Fläche von mindestens 20m x 20m erfüllt sein muß.

Nahfeldscanner sollten radartechnisch möglichst unsichtbar sein, was meist im Widerspruch zu dem mechanischen Aufwand für solche Scanner steht und in der Regel nur durch entsprechende Absorberverkleidungen erzielt werden kann.

Um ein Maximum an Phasengenauigkeit der Messung zu erhalten, sollte eine Datenaufnahme sämtlicher Meßpunkte möglichst schnell erfolgen, um Phasendriften über die Zeit möglichst gering zu halten.

Ausgehend von dem genannten Beispiel mit einer abzutastenden Fläche von 20m x 20m und einem Meßpunktabstand von 75mm ergeben sich bei einer Verteilung von 267 Meßpunkten in der Breite und 267 über die Höhe der Antenne insgesamt zumindest 71.289 Meßpunkten. Aus dieser Überschlagsrechnung ist ersichtlich, daß es einen nicht zu vertretenden Aufwand bedeuten würde, jeden einzelnen der Meßpunkte anzufahren, so daß die Messung während der Fahrt beim Passieren der Meßposition erfolgen muß. Bei einer Scangeschwindigkeit von 100 mm/sek würde die Datenaufnahme dabei ca. 15 Stunden in Anspruch nehmen.

Aus Stehle et al. "Reledop: A Full-Scale Antenna Pattern Measurement" I.E.E.E. Trans. On Broadcasting, Band 34 Nr. 2 Juni 1988 (1988/06, Seiten 210-220 YP 000054225 New York, US) und auch Henß: Hubschrauber-Messung" NTZ Nachrichtentechnische Zeitschrift Band 40 Nr. 4 April 1987 (1987/04, Seiten 258-261, YP-002168218) Berlin, DE) ist es bekannt, Sonden mittels eines pilotengesteuerten Hubschraubers unter Zwischenschaltung von einem langen Schleppseil respektive einer Teleskopstange in einem zu vermessenden Feld anzuordnen. Sowohl die Verwendung eines realen Hubschraubers als auch die Zwischenschaltung von langen Schleppseilen bzw. Teleskopstangen ermöglichen keine hochgenaue Vermessung und insbesondere auch keine hochgenaue Positionierung innerhalb des zu vermessenden Feldes.

Die Aufgabe der vorliegenden Erfindung ist es, eine Anordnung und ein Verfahren zur hochgenauen Charakterisierung von Strahlungsfeldern vorzusehen, mit der sich hochgenaue und großflächige Messungen von Strahlungsfeldem vor allem im Außenbereich, bei verhältnismäßig geringem Aufwand durchführen läßt.

Diese Aufgabe wird durch die Merkmale der unabhängigen Patentansprüche gelöst, wobei zweckmäßige Ausführungsformen durch die Merkmale der abhängigen Unteransprüche beschrieben sind.

Vorgesehen ist eine, insbesondere mobile, Meßanordnung zur Ausrichtung/Positionierung und/oder Erfassung der elektromagnetischen Charakteristika von Einrichtungen zur/mit Abgabe von Strahlungsfeldern, die sich nach Maßgabe der Erfindung dadurch auszeichnet, daß eine fernsteuerbare, mit einer Meßsonde zur Erfassung des gerichteten Signals schwebefähige Meßeinrichtung vorgesehen ist, die zumindest eine durch Vorrichtungen zur Bestimmung von Lage und Position erfaßbare Einrichtung zur Bestimmung von Lage und Position der Meßeinrichtung aufweist.

Bei den Vorrichtungen zur Bestimmung von Lage und Position handelt es sich vorzugsweise um am Ort der Abgabeeinrichtung verfügbare Positionsbestimmungssysteme und bei den Einrichtungen um Positionsempfänger/-antennen, wobei der oder die Positionsempfänger/-antennen in einer definierten Relativposition zur schwebenden Meßeinrichtung vorgesehen sind.

Bei der Meßanordnung nach Maßgabe der vorliegenden Erfindung wird als Positionsbestimmungssystem vorzugsweise ein globales, nichtterrestrisches Standortbestimmungssystem wie z.B. GPS verwendet, mit dem Positionen mit relativ großer Genauigkeit ermittelt werden können.

Weiterhin bevorzugt ist, daß der/die Positionsempfänger/-antenne des System zur Standort, Positions- und Lagemessung an der Meßsonde angeordnet ist. Um eine möglichst exakte Übereinstimmung zwischen der elektromagnetischen Messung und der Positionsbestimmung bzw. -ausrichtung der abstrahlenden Einrichtung zu erhalten, sollte das Phasenzentrum der Meßsonde so nah als möglich bei dem Positionsempfänger/-antenne liegen.

Bei der Abgabeeinrichtung handelt es sich darüber hinaus vorzugsweise um eine Antenne und im spezielleren um eine Parabolantenne oder eine Array-Antenne.

Die Meßanordnung kann darüber hinaus derart ausgebildet sein, daß die Meßeinrichtung eine Kombination aus Positionsempfänger/-antenne, einem Kompaß, einer Einrichtung zur Messung der Massenträgheitskräfte und einem oder mehreren Rotations-Sensoren zur Bestimmung und Regelung der Lage der schwebenden Einrichtung aufweist. Soweit es im speziellen Anwendungsfall notwendig sein sollte, können zu den genannten Komponenten natürlich auch noch andere kommen.

Die Meßanordnung nach Maßgabe der vorliegenden Erfindung kann ferner derart ausgebildet sein, daß die Meßeinrichtung eine Mehrzahl räumlich voneinander getrennt an der schwebenden Einrichtung angeordneten Positionsempfängern/-antennen aufweist, was die Anwendung eines differentiellen Verfahrens zur Positions- und Lagebestimmung der schwebenden Einrichtung ermöglicht.

Schließlich kann bei der erfindungsgemäßen Meßanordnung ein zusätzlicher Positionsempfänger/-antenne als Referenz am Boden im Bereich der Abgabeeinrichtung vorgesehen sein, was die Anwendung eines differentiellen Verfahrens zur Positions- und Lagebestimmung der schwebenden Einrichtung ermöglicht.

Bei einer derart ausgebildeten Meßanordnung ist kein direkter Sichtkontakt zwischen einer Bodenstation, an der z.B. Meßgeräte zu Verarbeitung der von der Meßsonde gelieferten Daten sowie Einrichtungen zur Steuerung der schwebenden Meßeinrichtung vorgesehen sein können, und dem Empfänger notwendig, was insbesondere bei sphärischen Scankonturen von Vorteil sein kann.

Die Anordnung aus Posifionsempfänger/-antennen und/oder der Meßsonde kann vorteilhafterweise an der schwebenden Einrichtung in solch einer Weise vorgesehen sein, daß eine winkelmäßige Einstellung, ein Verschwenken oder auch eine Stabilisierung der Meßsonde möglich ist um zum Beispiel auch bei Windeinwirkung eine gewünschte Ausrichtung unabhängig von einer Schräglage der schwebenden Einrichtung, zum Beispiel einem Helikopter, zu gewährleisten. Insbesondere kann sowohl eine Stabilisierung für kleine Positions- und Winkelausschläge vorgesehen sein, die der Relativposition zu der Abgabeeinrichtung Rechnung tragen kann. Diese Stabilisierung und/oder Positionierung kann vorteilhafterweise auch mit dem Meßregelkreis zusammenwirken, so daß ein entsprechendes Nachführen dargestellt werden kann. Hierdurch läßt sich somit ein Toleranzenausgleich und somit eine Beschleunigung der einzelnen Messungen erzielen.

Alternativ kann die Meßanordnung zur hochgenauen Ausrichtung/Positionierung und/oder Erfassung von elektromagnetischen Charakteristika von Einrichtungen zur/mit Abgabe von gerichteten strahlungs- und/oder wellenförmigen Signalen auch derart ausgebildet sein, daß an der schwebend vor der Abgabeeinrichtung zu plazierenden Meßsonde zur Erfassung des Signals Einrichtungen vorgesehen sind, deren relative momentane Meßposition durch zumindest eine Anordnung zur Positionsmessung mit einem geodätischen Gerät erfaßbar ist, das mit einer Einrichtung zur Abgabe eines definierten optischen Signals sowie einer Einrichtung zum Empfang eines optischen Signals versehen ist, sowie mit einer Einrichtung zur Reflexion des definierten optischen Signals des geodätischen Gerätes an der zu vermessenden Position, wobei die Einrichtung zur Reflexion des definierten optischen Signals beispielhaft durch eine reflektierende kugelsphärische Reflexionsfläche gebildet ist, so daß die Reflexion des definierten optischen Signals für den Betrachter auf einen Punkt reduziert ist und wobei der oder die sphärischen Reflexionsflächen in einer definierten Relativposition zur schwebenden Einrichtung und/oder der Meßsonde vorgesehen sind.

Diese Meßanordnung kann dabei derart ausgebildet sein, daß die Reflexionsfläche Teil einer verspiegelten Kugel ist.

Diese Meßanordnung ist darüber hinaus vorzugsweise derart ausgebildet, daß die geodätische Einrichtung zum Empfang eines optischen Signals mit einem konkaven Primärspiegel, einem konvexen Sekundärspiegel sowie einer in zwei Dimensionen sensitiven Detektoreinrichtung, z.B. Positionsdiode zur Erzeugung eines Ablesesignals versehen ist. Alternativ zu den Spiegeln sind auch andere optische Systeme wie Reflektoren/Refraktoren einsetzbar.

Weiterhin kann diese Meßanordnung derart ausgebildet sein, daß der Sekundärspiegel im wesentlichen im Brennpunkt des Primärspiegels und die Detektoreinrichtung dem Sekundärspiegel gegenüber im Bereich des Primärspiegels plaziert ist, wobei die Detektoreinrichtung vorzugsweise hinter einer Öffnung im Primärspiegel plaziert ist, durch die das im Sekundärspiegel fokussierte, reflektierte optische Signal hindurchgeht.

Ebenso bevorzugt sind jeder Reflexionseinrichtung zwei geodätische Geräte zugeordnet, so daß eine Kreuzpeilung ermöglicht ist.

Das von dem geodätischen Gerät abgegebene optische Signal ist vorzugsweise ein Laserstrahl, insbesondere ein leistungseinstellbarer und/oder modulierbarer Laserstrahl, wobei das geodätische Gerät mit hochgenauen Winkelencodern in Azimut und Elevation versehen sein kann, zur dynamisch genauen Erfassung der Anpeilwinkel zu dem jeweiligen Reflektor. Beispielhaft können beim Einsatz von zwei Laserstrahlen diese mit unterschiedlicher Frequenz moduliert werden, so daß eine Identifikation des reflektierten Signals möglich ist. Ferner ist bei einer insbesonders bevorzugten Ausführungsform möglich, die Leistungseinstellungsmöglichkeit abhängig von der Entfernung zwischen Laserquellereflektor und Detektoreinrichtung, wodurch sich eine Beschädigung der Diode durch übermäßige Lasereinstrahlung vermeiden läßt. Es hat sich als besonders vorteilhaft herausgestellt für den Laserstrahl einen Halbleiterlaser einzusetzen, wobei die Modulation alternativ oder unterstützend auch durch Frequenzfilter dargestellt werden kann.

Diese Meßanordnung ist dabei vorzugsweise derart ausgebildet, daß drei der genannten Anordnungen vorgesehen sind, mit drei an der schwebenden Einrichtung in definierter Relativposition vorgesehenen Reflexionsflächen.

Die Meßanordnung selbst ist in der Lage in an und für sich bekannter Weise elektromagnetische Charakteristiken zu erfassen, wobei zu diesem Zweck üblicherweise eine Meßsonde zum Einsatz kommt. Somit kann eine wechselseitige Beziehung zwischen elektromagnetischer Messung, Meßort und/oder Position der abstrahlenden Einrichtung erzielt werden. Durch die hoch genaue relative Bestimmung der drei Parameter: Position, Feld und Felderzeugung, ist es in einfacher Weise möglich, eine Vielzahl von hoch genauen Messungen durchzuführen, wobei die Meßsonde beispielhaft unter Einsatz der eingangs beschriebenen Nahfeldmeßtechnik betrieben werden kann.

Weiterhin bevorzugt ist, daß eine der sphärischen Reflexionsflächen an der Meßsonde angeordnet ist. Um eine möglichst exakte Übereinstimmung zwischen der elektromagnetischen Messung und der Positionsbestimmung bzw. -ausrichtung der abstrahlenden Einrichtung zu erhalten, sollte das Phasenzentrum der Meßsonde so nah als möglich bei dem Mittelpunkt der sphärischen Reflexionsfläche liegen, wobei ein Optimum an Genauigkeit erhalten wird, wenn Kugelmittelpunkt und Phasenzentrum übereinstimmen. Bei der Abgabeeinrichtung handelt es sich darüber hinaus vorzugsweise um eine Antenne und im spezielleren um eine Parabolantenne oder eine Array-Antenne.

Neben den oben aufgeführten Merkmalen kann es bei dieser Meßanordnung von Vorteil sein, wenn man bei der Abbildung des reflektierten Laserstrahls eine Autofokussiereinrichtung vorsieht, wobei dies die schnelle Erfassung von einzelnen Meßpunkten und die Genauigkeit derselben unterstützt. Ferner ist zu erwähnen, daß auch die Relativposition der Diode bzw. der Detektoreinrichtung im Anzeigebereich ausgewertet werden kann, um die Meßgenauigkeit noch weiter zu erhöhen.

Die Größe und Masse der schwebenden Einrichtung im Verhältnis zu der Abgabeeinrichtung ist dabei klein gewählt, da Objekte in einem zu vermessenden elektromagnetisches Feld zu erheblichen Meßfehlern führen können. Um dieser Forderung gerecht zu werden, bietet es sich an z.B. einen Miniaturhubschrauber als schwebende Einrichtung vorzusehen, wobei aber auch andere Alternativen, wie gesteuerte Ballone, Zeppeline, o.ä. denkbar sind, die vorzugsweise funkferngesteuert sind.

Die Erfindung sieht neben der Meßanordnung auch ein Verfahren zur hochgenauen Charakterisierung von Strahlungsfeldern, insbesondere für den mobilen Einsatz und/oder im Außenbereich, vor, das nach Maßgabe der Erfindung die folgenden Schritte umfaßt:
1. die schwebende Anordnung einer fernsteuerbaren Meßeinrichtung im Strahlungsfeld, mit einer Meßsonde zur Erfassung des Strahlungsfeldes sowie mit zumindest einer durch Vorrichtungen zur Bestimmung von Lage und Position erfaßbaren Einrichtung zur Bestimmung von Lage und Position der Meßeinrichtung;
2. die Bestimmung der Position und Lage der Meßeinrichtung; und
3. die Erzeugung eines Meßsignales zur Charakterisierung des Strahlungsfeldes;
4. die Übertragung des Meßsignals von dem schwebenden Teil der Meßanordnung zu dem bodenseitigen Meßinstrumentarium.
5. die mehrfache Wiederholung der Schritte 1-5.

Das Verfahren nach Maßgabe der Erfindung kann dabei derart ausgestaltet sein, daß die Koordinaten der Vorrichtung/en zur Bestimmung von Lage und Position erfaßbaren Einrichtung zur Bestimmung von Lage und Position der Meßeinrichtung in den drei Raumdimensionen bestimmt werden und aus diesen Koordinaten dynamisch die Ist-Position und die Ist-Lage aller sechs Freiheitsgrade der Meßeinrichtung insbesondere in Echtzeit bestimmt wird.

Darüber hinaus kann die Ist-Position und die Ist-Lage aller sechs Freiheitsgrade der Meßeinrichtung mit der vorgegebenen Soll-Position und Soll-Lage verglichen und in einer Regelschleife mit der Steuerung der Meßeinrichtung ausgeregelt werden, wobei bei der Ausregelung die Stabilisierung oder Positionierung der Meßsonde herangezogen wird.

Schließlich ist für den Fachmann ersichtlich, daß obwohl in der vorliegenden Anmeldung von einer abstrahlenden Einrichtung gesprochen wird, die Erfindung selbstverständlich in Umkehrung/Ergänzung auch auf den Fall einer Empfangsanlage oder auch einer feldverändernden, insbesondere reflektierenden, Einrichtung Anwendung finden kann.

Die entscheidenden Vorteile von Meßanordnungen oder -anlagen, die entsprechend dieser Erfindung konstruiert sind, liegen darin, daß sie durch ihre Mobilität eine vollständige Charakterisierung von Strahlungseigenschaften großer meist stationärer Antennenanlagen im Außenbereich überhaupt ermöglichen und dieses zudem noch in hochgenauer Weise.

Weitere Vorteile der erfindungsgemäßen Lösung sind u.a.:
- Hohe Positioniergenauigkeit von ca. 2,0 mm auf 50 m
- Große Positionierbereiche bis zu 100m Kantenlänge eines Würfels
- Hohe Positioniergeschwindigkeit < 1,0 min über 100 m Positionierstrecke
- Hochgenaue Erfassung aller 6 Freiheitsgrade von 0,5 mm und 1,0 Winkelminuten auf 50m Entfernung
- Mobilität
- Geringerer Installationsaufwand
- Breites Anwendungsspektrum (Antennenvermessungen, Radar-Rückstreumessungen, EMV-Messungen, Umweltmessungen, etc.)

Weitere Eigenschaften und Vorteile der Erfindung ergeben sich aus der folgenden Beschreibung bevorzugter Ausführungsformen der Erfindung, mit Bezug auf die beigefügten Zeichnungen; darin zeigt:
- Fig. 1: die schematische Darstellung einer Ausführungsform eines geodätischen Gerätes zur Positionsmessung;
- Fig. 2: die schematische Seitenansicht einer Ausführungsform der Meßanordnung zur Positionierung mit geodätischen Geräten;
- Fig. 3 bis 5: die Ansicht einer Ausführungsform der schwebenden Einrichtung;
- Fig. 6: die Meßanordnung nach Fig. 2 in der Draufsicht;
- Fig. 7: die Meßanordnung nach Fig. 2 in der Vorderansicht; und
- Fig. 8: eine schematische Darstellung des Regelungs- und Steuerungskonzeptes.
- Fig. 9: die schematische Seitenansicht einer Ausführungsform der Meßanordnung zur Positionierung mit Positionsbestimmungssystemen;
- Fig.10: die Meßanordnung nach Fig. 9 in der Draufsicht;
- Fig. 11: die Meßanordnung nach Fig. 9 in der Vorderansicht.

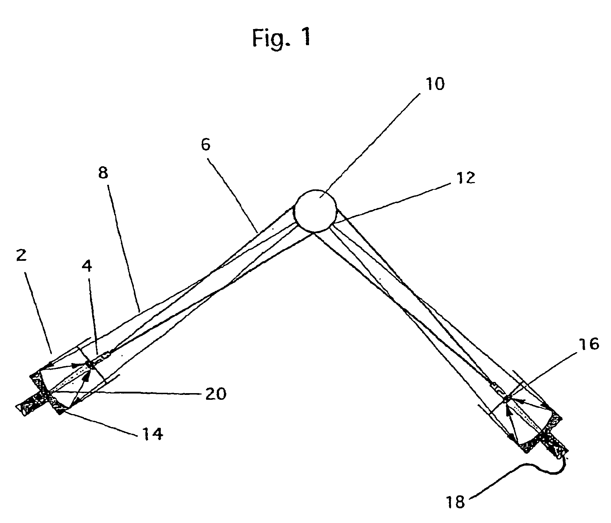

Die Fig. 1 zeigt eine Ausführungsform einer Anordnung zur Positionsmessung, mit zwei geodätischen Geräten 2, hier optischen Theodoliten, die jeweils mit einer Einrichtung 4 zur Abgabe eines definierten optischen Signals 6, hier ein Laserstrahl, sowie einer Einrichtung zum Empfang eines optischen Signals 8 versehen ist, sowie mit einer Einrichtung 10 zur Reflexion des definierten optischen Signals 6 des geodätischen Gerätes 2 an der zu vermessenden Position, wobei die Einrichtung 10 zur Reflexion des definierten optischen Signals 6 hier durch eine reflektierende bzw. verspiegelte Kugel 10 gebildet ist, so daß die Reflexion des definierten optischen Signals 6 für den Betrachter auf einen Punkt 12 reduziert ist.

Wie der Fig. 1 weiterhin zu entnehmen ist, ist die geodätische Einrichtung 2 zum Empfang des reflektierten optischen Signals 8 mit einem konkaven Primärspiegel 14, einem konvexen Sekundärspiegel 16 sowie einer in zwei Dimensionen sensitiven Detektoreinrichtung 18 zur Erzeugung eines Ablesesignals versehen. Der Sekundärspiegel 16 ist dabei im Brennpunkt des Primärspiegels 14 angeordnet, wobei die Detektoreinrichtung 18 dem Sekundärspiegel 16 gegenüber im Bereich des Primärspiegels 14 hinter einer Öffnung 20 im Primärspiegel plaziert ist, durch die das im Sekundärspiegel 16 fokussierte, reflektierte optische Signal 8 hindurchgeht. Das geodätische Gerät 2 ist in der dargestellten Ausführungsform mit hochgenauen Winkelencodern und Nachführantriebe in Azimut und Elevation versehen, zur dynamisch genauen Erfassung/Nachführung der Anpeilwinkel zu dem jeweiligen Reflektor, mit Hilfe der Detektoreinrichtung 18.

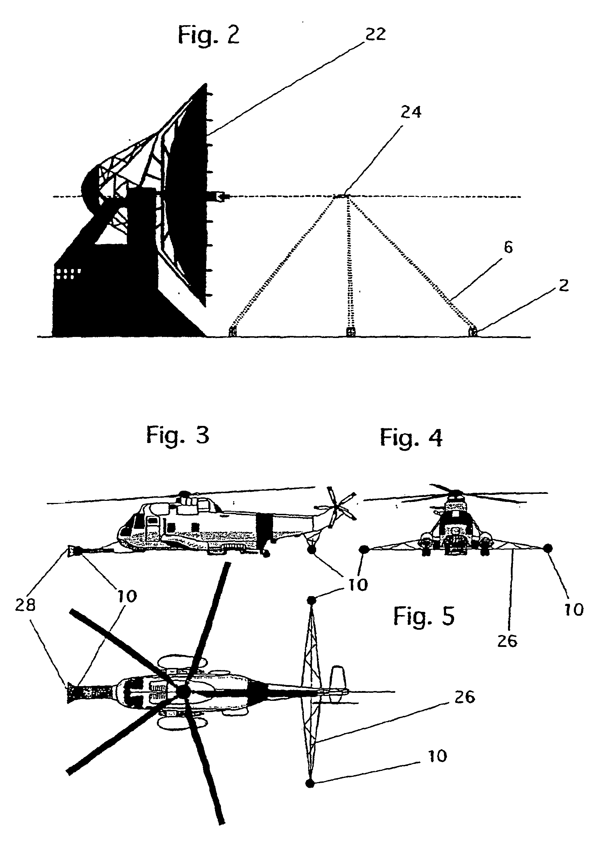

Die Fig. 2 zeigt die Ausführungsform einer Meßanordnung zur hochgenauen Ausrichtung/Positionierung einer Einrichtung zur Abgabe von gerichteten strahlungs- und/oder wellenförmigen Signalen, hier einer Parabolantenne 22, wobei bei der Meßanordnung der dargestellten Ausführungsform eine mit einer Meßsonde zur Erfassung des Signals der Antennen 22 versehene, vor derselben schwebende Einrichtung 24 vorgesehen ist, deren Position durch eine Anzahl von Anordnungen zur Positionsmessung, wie in der Fig. 1 dargestellt, erfaßbar ist. Der Fig. 2 sind dabei sechs optische Theodoliten 2 zu entnehmen, wobei die von diesen ausgehenden Laserstrahlen 6 auf an der vor der Antenne 22 schwebenden Einrichtung 24 befestige Reflektoren gerichtet sind.

Die Figuren 3 bis 5 zeigen die schwebende Einrichtung 24 der Ausführungsform nach Fig. 2 in größerem Detail. Zu erkennen ist dabei, daß hier ein, vorzugsweise miniaturisierter, Hubschrauber Verwendung findet, der mit drei durch Vorrichtungen zur Bestimmung von Lage und Position erfaßbaren Einrichtungen 10 zur Bestimmung von Lage und Position der Meßeinrichtung 24 versehen ist, die an Auslegern 26 bzw. an der Meßsonde 28 zur Erfassung des Antennensignales, in einer definierten Position zu dem Hubschrauber befestigt sind. Bei diesen Einrichtungen kann es sich z.B. um verspiegelte Kugeln 10, wie mit Bezug auf Fig. 1 beschrieben, handeln, oder aber um Positionsempfänger/-antennen 10 für am Ort der Abgabeeinrichtung 22 verfügbare Positionsbestimmungssysteme (nicht dargestellt).

Der Miniaturhubschrauber kommt bei der dargestellten Ausführungsform daher zum Einsatz, da er geeignet ist, eine stabile schwebende Position vor der zu vermessenden Antenne 22 einzunehmen, dieser gegenüber eine geringe Masse hat, so daß praktisch keine Meßfehler durch den Hubschrauber zu erwarten sind, und sich mit einfacher und jederzeit verfügbarer Technik steuern läßt. Um den Meßfehler noch weiter zu reduzieren, kann eine nicht dargestellte Positionier- und/oder Stabilisiereinrichtung vorgesehen sein, die eine gewisse Entkopplung bezüglich des Hubschraubers darstellt und eine nahezu willkürliche Position desselben mit Bezug auf die abstrahlende Einrichtung ermöglicht. Wenn zum Beispiel der Hubschrauber über der abstrahlenden Einrichtung vorliegt, so sollte die Meßsonde im wesentlichen nach unten ausgerichtet vorliegen.

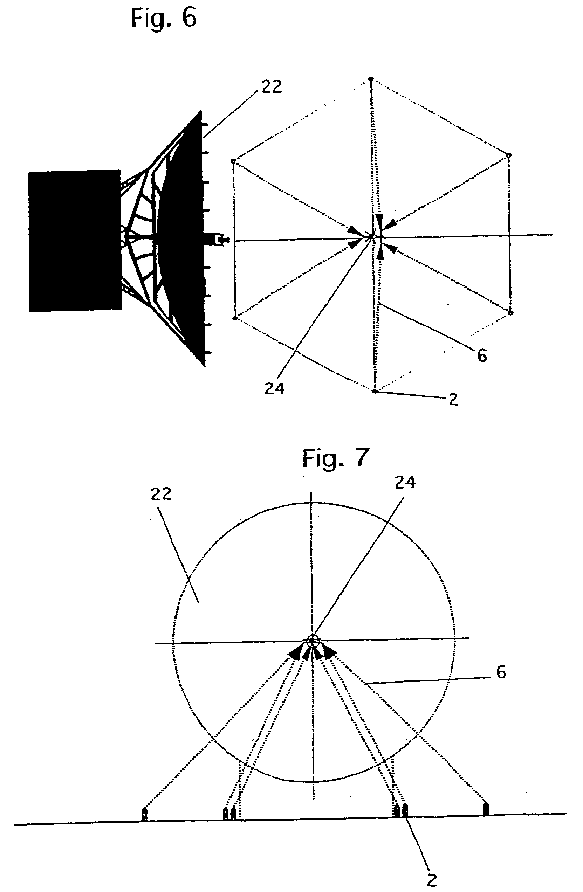

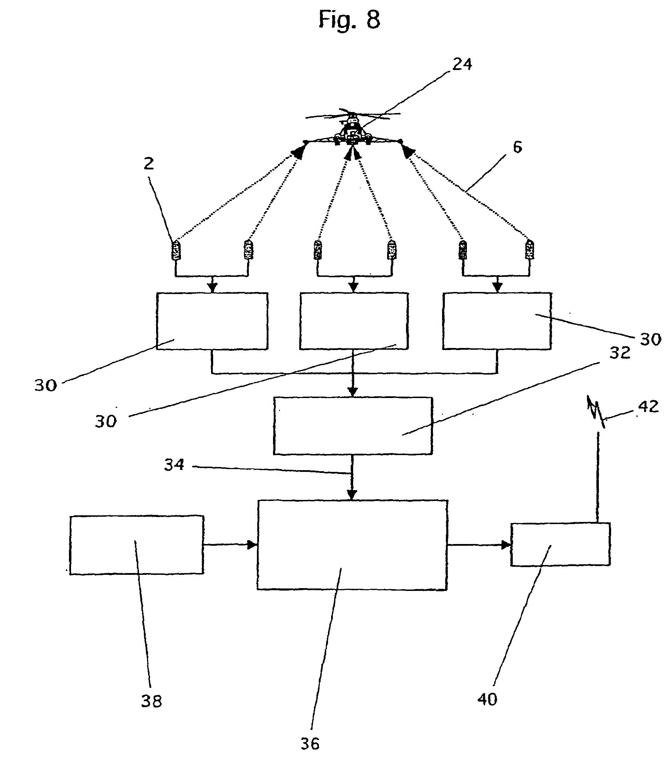

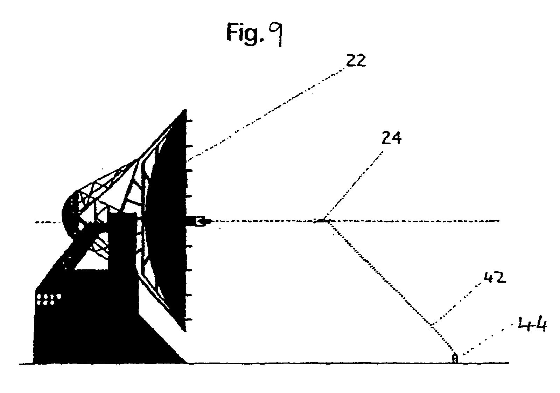

Die Figuren 6 und 7 zeigen die Ausführungsform der Fig. 2 in Draufsicht und Vorderansicht, wobei gleiche Elemente mit entsprechenden Bezugszeichen versehen sind.

Die Meßanordnung nach Maßgabe der Figuren 2 bis 7 arbeitet derart, daß die Positionen der Laserreflektoren 10, die an dem Hubschrauber befestigt sind, jeweils mit zwei der hochgenauen Winkelmeßgeräte 2 in Azimut und Elevation bestimmt werden. Eine automatische Zielverfolgung erfolgt dabei basierend auf dem aus dem jeweiligen Winkelmeßgerät bzw. optischen Theodoliten 2 ausgesandten Laserstrahl 6, z.B. mittels Nachführungseinrichtung.

Beim Einsatz von mehreren Laserstrahlen sollten diese voneinander unterscheidbar sein. Zu diesem Zweck können zum Beispiel modulierbare Halbleiterlaser oder auch Laser mit nachgeschalteten Frequenzfiltern zum Einsatz kommen, so daß jeder Laserstrahl über spezifische eigene Charakteristiken verfügt, die dessen Identifikation erlauben.

Dieser Laserstrahl 6 wird an einem der am Hubschrauber montierten Laserreflektoren 10 reflektiert und durch das im jeweiligen Winkelmeßgerät 2 befindliche optische Teleskop 14, 16 auf der in zwei Dimensionen sensitiven Detektoreinrichtung 18 abgebildet. Durch eine Bewegung des Hubschraubers und somit der Laserreflektoren 10, wird ein Ablagesignal erzeugt und in einen Regelkreis eingespeist, der eine Nachführung mittels nicht dargestellter Nachführantriebe in Azimut und Elevation veranlaßt. Hochgenaue Winkelencoder in Azimut und Elevation (nicht dargestellt) liefern dynamisch genau die Anpeilwinkel zu dem jeweiligen Laserreflektor 10. Da, wie in den Figuren 2, 6 und 7 dargestellt, jeweils zwei Winkelmeßgeräte 2 den selben Laserreflektor 10 anpeilen, können die Koordinaten des jeweiligen Laserreflektors 10 in den drei Raumdimensionen bestimmt werden. Aus den Koordinaten der drei Laserreflektoren 10 wird sodann dynamisch die Ist-Position und die Ist-Lage aller sechs Freiheitsgrade des Hubschraubers 24 bestimmt. Diese Information wird mit der vorgegebenen Soll-Position und Soll-Lage verglichen und in einer Regelschleife mit der Hubschraubersteuerung ausgeregelt. Durch dieses Verfahren kann der Hubschrauber bzw. die an diesem montierte Meßsonde 28 zur Erfassung des gerichteten Signals der Antenne 22 in allen 6 Freiheitsgraden in Höhen bis 100m mit größter Genauigkeit positioniert werden. Der Downlink von dem Hubschrauber 24 als schwebender Einrichtung erfolgt nach bekannten Übertragungskonzepten, wobei die Kopplung über eine dehnungsfehlerbereinigte Glasfaseranordnung neben anderen Möglichkeiten bevorzugt ist. Es ist jedoch in jedem Fall darauf zu achten, daß hierdurch kein Fehler, wie z.B. eine Phasenverschiebung auftritt.

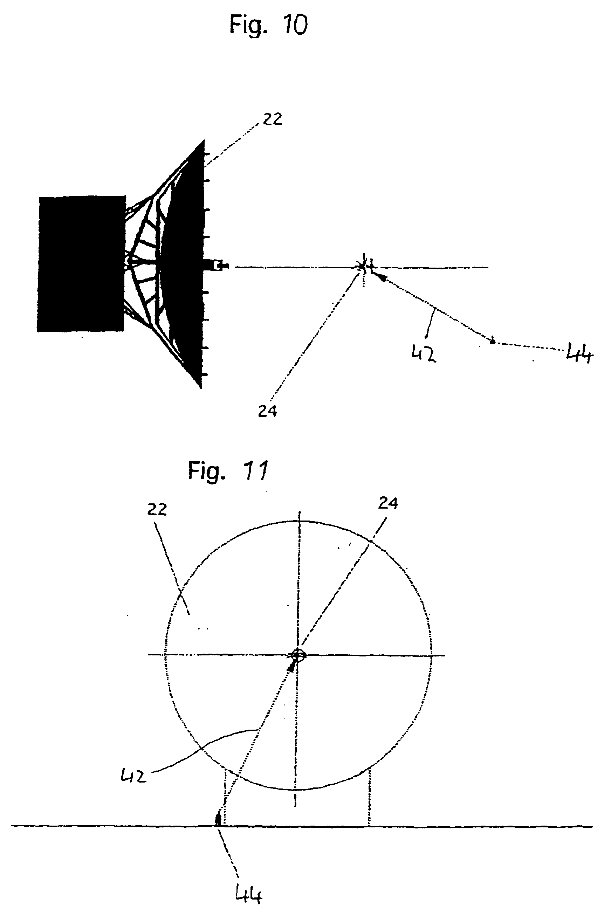

In der Fig. 8 ist das Regelungs- und Steuerkonzept der vorliegenden Erfindung dargestellt. Die Winkelmeßgeräte 2 sind mit Positionsrechnern 30 verbunden, die die jeweilige Position eines Reflektors 10 in Real Time berechnen. Die derart ermittelten Positionsdaten werden an den Positions- und Lagerechner 32 der schwebenden Einrichtung 24 übermittelt. An dem Punkt 34 werden die Ist-Werte für Position und Lage eingespeist, woraufhin bei 36 ein Soll/Ist-Vergleich bezüglich Position und Lage der unter Berücksichtigung der aus der Anwendung stammenden Soll-Werte 38 für Position und Lage erfolgt und auf der Basis dieses Vergleiches Stellgrößen für die Hubschraubersteuerung 40 erzeugt werden, die über eine Fernsteuerung 42 an den Hubschrauber 24 übermittelt werden.

Die Fig. 9 zeigt eine weitere Ausführungsform einer Meßanordnung zur hochgenauen Charakterisierung von Strahlungsfeldern. Gleiche Elemente wie in den Figuren 1 bis 8 sind dabei auch mit gleichen Bezugszeichen versehen. Bei der Meßanordnung der dargestellten Ausführungsform ist ebenfalls eine fernsteuerbare, mit einer Meßsonde 28 zur Erfassung des gerichteten Signals sowie mit zumindest einem Positionsempfänger/-antenne 10 für am Ort der Abgabeeinrichtung 22 verfügbare Positionsbestimmungssysteme (nicht dargestellt) versehene, schwebefähige Meßeinrichtung 24 vorgesehen ist. Bei der Meßanordnung nach Maßgabe der vorliegenden Erfindung wird als Positionsbestimmungssystem vorzugsweise ein globales, nichtterrestrisches Standortbestimmungssystem wie z.B. GPS verwendet, mit dem Positionen über der Erdoberfläche mit relativ großer Genauigkeit ermittelt werden können. An einer Bodenstation ist ein weiterer stationärer Positionsempfänger/-antenne 44 vorgesehen. Die Meßeinrichtung 24 ist über einen Datenlink 42 mit einer Bodenstation bzw. dem dort vorgesehen Positionsempfänger/-antenne 44 verbunden, der eine hochgenaue Referenzposition liefert.

Durch die Meßanordnung kann eine wechselseitige Beziehung zwischen elektromagnetischer Messung, Meßort und/oder Position der abstrahlenden Einrichtung 22 erzielt werden. Durch die hochgenaue relative Bestimmung der drei Parameter: Position, Feld und Felderzeugung, ist es in einfacher Weise möglich, eine Vielzahl von hoch genauen Messungen durchzuführen, wobei die Meßsonde 28 beispielhaft unter Einsatz der Nahfeldmeßtechnik betrieben werden kann.

Zu bemerken ist dabei, daß hier der, vorzugsweise miniaturisierte, Hubschrauber, wie mit Bezug auf die Figuren 3 bis 5 beschrieben, mit drei Positionsempfängern/-antennen 10 für ein Navigations- oder Positioniersystem, wie z.B. GPS, versehen ist, die an den Auslegern 26 bzw. an der Meßsonde 28, in einer definierten Position zu dem Hubschrauber bzw. zueinander befestigt sind. Um eine möglichst exakte Übereinstimmung zwischen der elektromagnetischen Messung und der Positionsbestimmung bzw. -ausrichtung der abstrahlenden Einrichtung 22 zu erhalten, liegt das Phasenzentrum der Meßsonde 28 sehr nahe bei einem Positionsempfänger/-antenne 10.

Durch das Vorschen einer Mehrzahl räumlich voneinander getrennt an dem Miniaturhubschrauber 24 angeordneter Positionsempfängern/-antennen 10 sowie des zusätzlichen Positionsempfänger/-antenne als Referenz am Boden im Bereich der Abgabeeinrichtung ist die Anwendung eines differentiellen Verfahrens zur Positions- und Lagebestimmung, wie z.B. DGPS des Hubschraubers 24 ermöglicht.

Bei einer gemäß der vorliegenden Erfindung ausgebildeten Meßanordnung ist kein direkter Sichtkontakt zwischen der Bodenstation 44, an der z.B. Meßgeräte zu Verarbeitung der von der Meßsonde gelieferten Daten sowie Einrichtungen zur Steuerung der schwebenden Meßeinrichtung 24 vorgesehen sein können, und dem jeweiligen Empfänger 10 notwendig, was insbesondere bei sphärischen Scankonturen von Vorteil sein kann.

Um den Meßfehler noch weiter zu reduzieren, kann eine nicht dargestellte Positionierund/oder Stabilisiereinrichtung vorgesehen sein, die eine gewisse Entkopplung bezüglich des Hubschraubers darstellt und eine nahezu wülkürliche Position desselben mit Bezug auf die abstrahlende Einrichtung ermöglicht. Wenn zum Beispiel der Hubschrauber über der abstrahlenden Einrichtung steht, so sollte die Meßsonde 28 im wesentlichen nach unten ausgerichtet sein.

Die Figuren 10 und 11 zeigen die Anordnung der Fig. 9 in Draufsicht und Vorderansicht.

Die Meßanordnung nach Maßgabe der Figuren 9 bis 11 arbeitet derart, daß die Positionen der Positionsempfänger/-antenne 10, die an dem Hubschrauber 24 befestigt sind, sowie des Positionsempfängers/-antenne 44 der Bodenstation jeweils bestimmt werden, woraus sich die jeweils momentane Position und Lage des Hubschraubers 24 vorzugsweise in Echtzeit errechnen läßt.

Durch die Verwendung eines entsprechenden Navigations- oder Positioniersystemes, wie z.B. GPS, können die Koordinaten des/der jeweiligen Positionsempfängers/-antennen 10 bestimmt werden. Aus den Koordinaten der drei Positionsempfänger/-antennen 10 sowie des Positionsempfängers/-antenne 44 wird sodann dynamisch die Ist-Position und die Ist-Lage aller sechs Freiheitsgrade des Hubschraubers 24 bestimmt. Diese Information wird mit der vorgegebenen Soll-Position und Soll-Lage verglichen und in einer Regelschleife mit der Hubschraubersteuerung ausgeregelt. Durch dieses Verfahren kann der Hubschrauber bzw. die an diesem montierte Meßsonde 28 zur Erfassung des gerichteten Signals der Antenne 22 in allen 6 Freiheitsgraden mit größter Genauigkeit positioniert werden. Der Downlink 42 von dem Hubschrauber 24 als schwebender Einrichtung erfolgt nach bekannten Konzepten, wobei die Übertragung der Meßsignale zur Charakterisierung des Strahlungsfeldes z.B. durch eine dehnungs- und temperaturfehlerbereinigte Glasfaseranordnung realisiert werden kann. Es ist jedoch in jedem Fall darauf zu achten, daß hierdurch keine unzulässigen Fehler, wie z.B. Phasenverschiebungen auftreten.

Das Regelungs- und Steuerkonzept der vorliegenden Erfindung sieht vor, daß Positionsrechner die jeweilige Position eines Positionsempfängers/-antenne 10 soweit möglich in Echtzeit berechnen. Die derart ermittelten Positionsdaten werden an einen Positionsrechner des Hubschraubers 24 übermittelt. Die Ist-Werte für Position und Lage werden in den Positionsrechner des Hubschraubers 24 eingespeist, woraufhin ein Soll/Ist-Vergleich bezüglich Position und Lage der unter Berücksichtigung der aus der Anwendung stammenden Soll-Werte für Position und Lage erfolgt und auf der Basis dieses Vergleiches Stellgrößen für die Hubschraubersteuerung erzeugt werden, die über eine Fernsteuerung an den Hubschrauber 24 übermittelt werden.

Mit der Anordnung nach Maßgabe der vorliegenden Erfindung läßt sich in einfacher und vorteilhafter Weise eine hohe Positioniergenauigkeit auch bei großen Positionierbereichen erzielen, wobei gleichzeitig hohe Positioniergeschwindigkeiten und eine hochgenaue Erfassung aller 6 Freiheitsgrade sowie vor allem eine hochgenaue Charakterisierung von Strahlungsfeldern möglich ist. Die Anordnung und das Verfahren sind dabei geeignet für Anwendungen im Außenbereich, gewährleisten Mobilität, benötigen einen geringen Installationsaufwand und haben ein breites Anwendungsspektrum (Antennenvermessungen, Radar-Rückstreumessung, EMV-Messungen, Umweltmessungen, etc.). Vor allen Dingen aber machen sie eine hochgenaue und großflächige Messung und Charakterisierung von Strahlungsfeldern im Außenbereich durch ihre Mobilität möglich.

## Patentansprüche

1. Meßanordnung aufweisend eine Abgabeeinrichtung (22) zur Abgabe von Strahlungsfeldern sowie eine Meßeinrichtung (24) zur Ausrichtung und/oder Positionierung und/oder Erfassung der elektromagnetischen Charakteristika der Abgabeeinrichtung (22), **dadurch gekennzeichnet, dass** als Meßeinrichtung (24) eine fernsteuerbare, eine Meßsonde (28) zur Erfassung des gerichteten Strahlungsfeldes vor der Abgabeinrichtung (22) aufweisende schwebefähige Meßeinrichtung (24) vorgesehen ist, die zumindest eine durch Vorrichtungen zur Bestimmung von Lage und Position erfassbare Einrichtung (10) zur Bestimmung von Lage und Position der Meßeinrichtung (24) aufweist, wobei Größe und Masse der Meßeinrichtung (24) im Verhältnis zu der Abgabeeinrichtung (22) klein gewählt sind.

2. Meßanordnung nach Anspruch 1, **dadurch gekennzeichnet, daß** es sich bei den Vorrichtungen zur Bestimmung von Lage und Position um am Ort der Abgabeeinrichtung (22) verfügbare Positionsbestimmungssysteme handelt und bei den Einrichtungen (10) um Positionsempfänger/-antennen, wobei der oder die Positionsempfänger/-antennen (10) in einer definierten Relativposition zur schwebenden Einrichtung (24) vorgesehen sind.

3. Meßanordnung nach Anspruch 2, **dadurch gekennzeichnet, daß** als Positionsbestimmungssystem ein globales, nichtterrestrisches Standortbestimmungssystem verwendet wird.

4. Meßanordnung nach einem der Ansprüche 1 bis 3, **dadurch gekennzeichnet, daß** ein/eine Positionsempfänger/-antenne (10) an der Meßsonde (28) angeordnet ist.

5. Meßanordnung nach Anspruch 4, **dadurch gekennzeichnet, daß** der/die Positionsempfänger/-antenne (10) in unmittelbarer Nähe des Phasenzentrums der Meßsonde (28) angeordnet ist

6. Meßanordnung nach einem der Ansprüche 2 bis 5, **dadurch gekennzeichnet, daß** die Meßeinrichtung (24) eine Kombination aus Positionsempfänger/-antenne (10), einem Kompaß, einer Einrichtung zur Messung der Massenträgheitskräfte und/oder Beschleunigungen und einem oder mehreren Rotations-Sensoren zur Bestimmung und Regelung der Lage der schwebenden Meßeinrichtung (24) aufweist.

7. Meßanordnung nach einem der Ansprüche 2 bis 6, **dadurch gekennzeichnet, daß** die Meßeinrichtung (24) eine Mehrzahl räumlich voneinander getrennt an der schwebenden Einrichtung angeordneten Positionsempfängern/-antennen (10) aufweist.

8. Meßanordnung nach einem der Ansprüche 1 bis 7, **dadurch gekennzeichnet, daß** ein/eine zusätzlicher/zusätzliche Positionsempfänger/-antenne (44) als Referenz am Boden im Bereich der Abgabeeinrichtung (22) vorgesehen ist

9. Meßanordnung nach Anspruch 1, **dadurch gekennzeichnet, daß** es sich bei den Vorrichtungen zur Bestimmung von Lage und Position um zumindest ein geodätisches Gerät (2) handelt, das mit einer Einrichtung (4) zur Abgabe eines definierten optischen Signals (6) sowie einer Einrichtung zum Empfang eines optischen Signals (8) versehen ist, und bei den Einrichtungen (10) zur Bestimmung von Lage und Position der Meßeinrichtung (24) um zumindest eine reflektierende, kugelsphärische Reflexionsfläche (10) zur Reflexion des definierten optischen Signals (6) des geodätischen Gerätes (2) an der zu vermessenden Position, so daß die Reflexion des definierten optischen Signals für den Betrachter auf einen Punkt (12) reduziert ist, wobei die sphärischen Reflexionsflächen/Sphärische Reflexionsfläche (10) in einer definierten Relativposition zur schwebenden Einrichtung (24) vorgesehen sind/ist.

10. Meßanordnung nach Anspruch 9, **dadurch gekennzeichnet, daß** die Reflexionsfläche Teil einer verspiegelten Kugel (10) ist.

11. Meßanordnung nach einem der Ansprüche 9 bis 10, **dadurch gekennzeichnet, daß** die Einrichtung zum Empfang eines optischen Signals mit einem konkaven Primärspiegel (14), einem konvexen Sekundärspiegel (16) sowie einer in zwei Dimensionen sensitiven Detektoreinrichtung wie einer Positionsdiode (18) zur Erzeugung eines Ablesesignals versehen ist.

12. Meßanordnung nach einem der Ansprüche 9 bis 11, **dadurch gekennzeichnet, daß** der Sekundärspiegel (16) im wesentlichen im Brennpunkt des Primärspiegels (14) und die Detektoreinrichtung (18) dem Sekundärspiegel (16) gegenüber im Bereich des Primärspiegels (14) plaziert ist.

13. Meßanordnung nach Anspruch 12, **dadurch gekennzeichnet, daß** die Detektoreinrichtung (18) hinter einer Öffnung (20) im Primärspiegel (14) plaziert ist.

14. Meßanordnung nach einem der Ansprüche 9 bis 13, **dadurch gekennzeichnet, daß** jeder Reflexionseinrichtung (10) zwei geodätische Geräte (2) zugeordnet sind, so daß eine Kreuzpeilung ermöglicht ist.

15. Meßanordnung nach einem der Ansprüche 9 bis 14, **dadurch gekennzeichnet, daß** das von dem geodätischen Gerät (2) abgegebene optische Signal ein Laserstrahl (6), insbesondere ein leistungseinstellbarer und/oder modulierbarer Laserstrahl (6) ist.

16. Meßanordnung nach einem der Ansprüche 9 bis 15, **dadurch gekennzeichnet, daß** das geodätische Gerät (2) mit hochgenauen Winkelencodern in Azimut und Elevation versehen ist, zur dynamisch genauen Erfassung der Anpeilwinkel zu dem jeweiligen Reflektor (10).

17. Meßanordnung nach einem der Ansprüche 9 bis 16, **dadurch gekennzeichnet, daß** drei reflektierende, kugelsphärische Reflexionsflächen (10) zur Reflexion des definierten optischen Signals (6) des geodätischen Gerätes (2) an der zu vermessenden Position vorgesehen sind.

18. Meßanordnung nach einem der Ansprüche 9 bis 17, **dadurch gekennzeichnet, daß** eine der sphärischen Reflexionsflächen (10) an der Meßsonde (28) angeordnet ist, wobei das Phasenzentrum der Sonde mit dem Mittelpunkt der sphärischen Reflexionsfläche im wesentlichen zusammenfällt.

19. Meßanordnung nach einem der vorhergehenden Ansprüche, **dadurch gekennzeichnet, daß** die Meßsonde (28) für den Einsatz in der Nahfeldmeßtechnik ausgebildet ist.

20. Meßanordnung nach einem der vorhergehenden Ansprüche, **dadurch gekennzeichnet, daß** die Meßeinrichtung (24) ein Miniaturhubschrauber ist

21. Meßanordnung nach einem der Ansprüche 1 bis 19, **dadurch gekennzeichnet, daß** die Meßeinrichtung (24) ein Ballon ist.

22. Meßanordnung nach einem der Ansprüche 1 bis 19, **dadurch gekennzeichnet, daß** die Meßeinrichtung (24) ein Zeppelin ist.

23. Meßanordnung nach einem der Ansprüche 1 bis 19, **dadurch gekennzeichnet, daß** die Meßeinrichtung (24) ein Flugzeug ist.

24. Verfahren zur hochgenauen Charakterisierung von Strahlungsfeldern unter Verwendung einer Meßanordnung nach einem der Ansprüche 1-23, **gekennzeichnet durch:**
a) die schwebende Anordnung einer fernsteuerbaren Meßeinrichtung (24) im Strahlungsfeld, mit einer Meßsonde (28) zur Erfassung des Strahlungsfeldes sowie mit zumindest einer **durch** Vorrichtungen zur Bestimmung von Lage und Position erfaßbaren Einrichtung (10) zur Bestimmung von Lage und Position der Meßeinrichtung (24);
b) die Bestimmung der Position und Lage der Meßeinrichtung (24);
c) die Erzeugung eines Meßsignals zur Charakterisierung des Strahlungsfeldes;
d) die Übertragung des Meßsignals von dem schwebenden Teil der Meßanordnung zu dem bodenseitigen Meßinstrumentarium;
e) die mehrmalige Wiederholung der Schritte a)-d).

25. Verfahren nach Anspruch 24, **dadurch gekennzeichnet, daß** die Koordinaten des/der jeweiligen Positionsempfängers/-antenne (10, 2) bestimmt werden und aus diesen Koordinaten dynamisch die Ist-Position und die Ist-Lage in allen sechs Freiheitsgraden der Meßeinrichtung insbesondere in Echtzeit bestimmt wird.

26. Verfahren nach Anspruch 24 oder 25, **dadurch gekennzeichnet, daß** die Ist-Position und die Ist-Lage in allen sechs Freiheitsgraden der Meßeinrichtung (24) mit der vorgegebenen Soll-Position und Soll-Lage verglichen werden und auf der Basis dieses Vergleiches Stellgrößen für die Steuerung der Meßeinrichung erzeugt werden.

## Claims

1. Measuring arrangement, comprising an emitting device (22) for emission of radiation fields as well as a measuring device (24) for aligning, and/or positioning, and/or detecting the electromagnetic characteristics of, the emitting device (22), **characterised in that** a remote-controllable, floating measuring device (24) having a measuring probe (28) for detecting the directional radiation field in front of the emitting device (22) is provided as the measuring device (24), which measuring device comprises at least one device (10) detectable by attitude- and position-determining means for determining attitude and position of the measuring device (24), the size and mass of the measuring device (24) being selected to be small in relation to the emitting device (22).

2. Measuring arrangement according to claim 1, **characterised in that** the means for determining attitude and position are position-determining systems situated at the location of the emitting device (22) and the devices (10) are position receivers/antennas, the position receiver(s)/antenna(s) (10) being provided in a defined position relative to the floating device (24).

3. Measuring arrangement according to claim 2, **characterised in that** a global, non-terrestrial location-fixing system is used as the position-determining system.

4. Measuring arrangement according to any one of claims 1 to 3, **characterised in that** a position receiver/antenna (10) is arranged on the measuring probe (28).

5. Measuring arrangement according to claim 4, **characterised in that** the position receiver/antenna (10) is arranged in the immediate vicinity of the phase centre of the measuring probe (28).

6. Measuring arrangement according to any one of claims 2 to 5, **characterised in that** the measuring device (24) comprises a combination of position receiver/antenna (10), a compass, a means for measuring mass inertia forces and/or accelerations and one or more rotation sensors for determining and controlling the attitude of the floating measuring device (24).

7. Measuring arrangement according to any one of claims 2 to 6, **characterised in that** the measuring device (24) comprises a plurality of spatially separated position receivers/antennas (10) arranged on the floating device.

8. Measuring arrangement according to any one of claims 1 to 7, **characterised in that** an additional position receiver/antenna (44) is provided as a reference on the ground in the region of the emitting device (22).

9. Measuring arrangement according to claim 1, **characterised in that** the means for determining attitude and position comprise at least one geodetic apparatus (2) that is provided with a device (4) for emitting a defined optical signal (6) as well as a device for receiving an optical signal (8), and the devices (10) for determining attitude and position of the measuring device (24) comprise at least one reflecting spherical reflective surface (10) for reflection of the defined optical signal (6) of the geodetic apparatus (2) at the position to be measured, so that the reflection of the defined optical signal is focused at a point (12) for the observer, the spherical reflective surfaces/spherical reflective surface (10) being provided in a defined position relative to the floating device (24).

10. Measuring arrangement according to claim 9, **characterised in that** the reflective surface is part of a reflecting sphere (10).

11. Measuring arrangement according to one of claims 9 and 10, **characterised in that** the device for receiving an optical signal is provided with a concave primary mirror (14), a convex secondary mirror (16) as well as a detector device sensitive in two dimensions such as a position diode (18) for generating a read-out signal.

12. Measuring arrangement according to any one of claims 9 to 11, **characterised in that** the secondary mirror (16) is located substantially at the focal point of the primary mirror (14) and the detector device (18) is located opposite the secondary mirror (16) in the region of the primary mirror (14).

13. Measuring arrangement according to claim 12, **characterised in that** the detector device (18) is placed behind an opening (20) in the primary mirror (14).

14. Measuring arrangement according to any one of claims 9 to 13, **characterised in that** two geodetic devices (2) are associated with each reflection device (10), thus rendering a cross bearing possible.

15. Measuring arrangement according to any one of claims 9 to 14, **characterised in that** the optical signal emitted by the geodetic apparatus (2) is a laser beam (6), especially a power-adjustable or modulatable laser beam (6).

16. Measuring arrangement according to any one of claims 9 to 15, **characterised in that** the geodetic apparatus (2) is provided with highly precise angle encoders in azimuth and elevation for dynamically accurate detection of the bearing angle to the respective reflector (10).

17. Measuring arrangement according to any one of claims 9 to 16, **characterised in that** three reflecting, spherical reflective surfaces (10) are provided for reflection of the defined optical signal (6) of the geodetic apparatus (2) at the position to be measured.

18. Measuring arrangement according to any one of claims 9 to 17, **characterised in that** one of the spherical reflective surfaces (10) is arranged on the measuring probe (28), the phase centre of the probe substantially coinciding with the midpoint of the spherical reflective surface.

19. Measuring arrangement according to any one of the preceding claims, **characterised in that** the measuring probe (28) is constructed for use in near-field metrology.

20. Measuring arrangement according to any one of the preceding claims, **characterised in that** the measuring device (24) is a miniature helicopter.

21. Measuring arrangement according to any one of claims 1 to 19, **characterised in that** the measuring device (24) is a balloon.

22. Measuring arrangement according to any one of claims 1 to 19, **characterised in that** the measuring device (24) is an airship.

23. Measuring arrangement according to any one of claims 1 to 19, **characterised in that** the measuring device (24) is an aircraft.

24. Method for the highly precise characterisation of radiation fields using a measuring arrangement according to any one of claims 1 to 23, **characterised by**
a) the floating arrangement of a remote-controllable measuring device (24) in the radiation field, having a measuring probe (28) for detecting the radiation field and also having at least one device (10) detectable by attitude- and position-determining means for determining attitude and position of the measuring device (24);
b) determining the position and attitude of the measuring device(24);
c) generating a measuring signal for characterising the radiation field;
d) transmitting the measuring signal from the floating part of the measuring arrangement to measuring instruments on the ground;
e) repetition several times over of the steps a) to d).

25. Method according to claim 24, **characterised in that** the co-ordinates of the respective position receiver/antenna (10, 2) are determined and from these co-ordinates the actual position and the actual attitude in all six degrees of freedom of the measuring device are dynamically determined in particular in real time.

26. Method according to claim 24 or 25, **characterised in that** the actual position and the actual attitude in all six degrees of freedom of the measuring device (24) are compared with the predetermined desired position and desired attitude and, on the basis of this comparison, correcting variables for the control of the measuring device are produced.

## Revendications

1. Système de mesure présentant un dispositif émetteur (22) destiné à émettre des champs de rayonnement, ainsi qu'un dispositif de mesure (24) destiné à orienter et/ou à positionner et/ou détecter des caractéristiques électromagnétiques du dispositif émetteur (22),
**caractérisé en ce qu'**
en tant que dispositif de mesure (24), on prévoit un dispositif de mesure (24) pivotant télécommandable présentant devant le dispositif émetteur (22) une tête de mesure (28) destinée à détecter le champ de rayonnement dirigé, lequel dispositif présente au moins un dispositif (10) détectable par des dispositifs destinés à déterminer l'emplacement et la position, destiné à déterminer l'emplacement et la position du dispositif de mesure (24), moyennant quoi la taille et la masse du dispositif de mesure (24) sont choisis petites par rapport au dispositif d'émission (22).

2. Système de mesure selon la revendication 1,
**caractérisé en ce que**
pour les dispositifs destinés à déterminer l'emplacement et la position, il s'agit de systèmes de détermination de position disponibles à l'endroit du dispositif d'émission (22) et pour les dispositifs (10), il s'agit de récepteurs/d'antennes de position, moyennant quoi le/la/les récepteur(s)/antenne(s) de position (10) sont prévus dans une position relative définie par rapport au dispositif flottant (24).

3. Système de mesure selon la revendication 2, **caractérisé en ce que** l'on utilise un système global de détermination de lieu non terrestre en tant que système de détermination de position.

4. Système de mesure selon l'une quelconque des revendications 1 à 3,
**caractérisé en ce qu'**
un récepteur/une antenne de position (10) est disposé(e) sur la tête de mesure (28).

5. Système de mesure selon la revendication 4,
**caractérisé en ce que**
le récepteur/l'antenne de position (10) est disposé(e) dans le voisinage direct du centre de phase de la tête de mesure (28).

6. Système de mesure selon l'une quelconque des revendications 2 à 5,
**caractérisé en ce que**
le dispositif de mesure (24) présente une combinaison d'un récepteur/d'une antenne de position (10), d'une boussole, d'un dispositif destiné à mesurer la force d'inertie de masse et/ou les vitesses et d'un ou de plusieurs capteurs de rotation destinés à déterminer et à réguler l'emplacement du dispositif de mesure flottant (24).

7. Système de mesure selon l'une quelconque des revendications 2 à 6,
**caractérisé en ce que**
le dispositif de mesure (24) présente plusieurs récepteurs/antennes de position (10) disposé(e)s sur le dispositif flottant séparés les uns des autres dans l'espace.

8. Système de mesure selon l'une quelconque des revendications 1 à 7,
**caractérisé en ce qu'**
un récepteur/une antenne de position (44) supplémentaire est prévu(e) comme référence au sol dans le secteur du dispositif d'émission (22).

9. Système de mesure selon la revendication 1,
**caractérisé en ce qu'**
il s'agit pour les dispositifs destinés à déterminer l'emplacement et la position d'au moins un appareil géodésique (2) qui est pourvu d'un dispositif (4) destiné à émettre un signal optique défini (6) ainsi que d'un dispositif destiné à recevoir un signal optique (8), et pour les dispositifs (10) destinés à déterminer l'emplacement et la position du dispositif de mesure (24), il s'agit au moins d'une surface réfléchissante sphérique (10) destinée à réfléchir le signal optique défini (6) de l'appareil géodésique (2) vers la position à mesurer, de telle sorte que la réflexion du signal optique défini soit réduite à un point (12) pour l'observateur, les surfaces de réflexion sphériques/la surface de réflexion sphérique, étant prévue(s) dans une position relative définie par rapport au dispositif (24).

10. Système de mesure selon la revendication 9,
**caractérisé en ce que**
la surface de réflexion fait partie d'une boule (10) sur laquelle est appliqué un revêtement réfléchissant.

11. Système de mesure selon l'une quelconque des revendications 9 à 10,
**caractérisé en ce que**
le dispositif de mesure destiné à recevoir un signal optique est muni d'un miroir primaire concave (14), d'un miroir secondaire convexe (16) ainsi que d'un dispositif détecteur bidimensionnel telle qu'une diode de position (18) pour générer un signal de lecture.

12. Système de mesure selon l'une quelconque des revendications 9 à 11,
**caractérisé en ce que**
le miroir secondaire (16) est placé essentiellement dans le foyer du miroir primaire (14) et le dispositif détecteur (18) est placé en face du miroir secondaire (16) dans la zone du miroir primaire ( 14).

13. Système de mesure selon la revendication 12,
**caractérisé en ce que**
le dispositif détecteur (18) est placé derrière une ouverture (20) dans le miroir primaire (14).

14. Système de mesure selon l'une quelconque des revendications 9 à 13,
**caractérisé en ce qu'**
à chaque dispositif réfléchissant (10) sont associés deux appareils géodésiques, ce qui permet un interception.

15. Système de mesure selon l'une quelconque des revendications 9 à 14,
**caractérisé en ce que**
le signal optique émanant de l'appareil géodésique (2) est un rayon laser (6), notamment un rayon laser (6) modulable et/ou à puissance réglable.

16. Système de mesure selon l'une quelconque des revendications 9 à 15,
**caractérisé en ce que**
l'appareil géodésique (2) est muni de codeurs d'angle ultra précis en azimut et en élévation, pour détecter de manière précise et dynamique l'angle d'intersection par rapport au réflecteur (10) correspondant.

17. Système de mesure selon l'une quelconque des revendications 9 à 16,
**caractérisé en ce que**
trois surfaces de réflexion sphériques (10) réfléchissantes sont prévues pour réfléchir le signal optique défini (6) de l'appareil géodésique (2) vers la position à mesurer.

18. Système de mesure selon l'une quelconque des revendications 9 à 17,
**caractérisé en ce qu'**
une des surfaces de réflexion sphériques (10) réfléchissantes est disposée sur la tête de mesure (20), le centre de phase de la tête coïncidant essentiellement avec le point central de la surface réfléchissante sphérique.

19. Système de mesure selon l'une quelconque des revendications précédentes,
**caractérisé en ce que**
la tête de mesure (28) est formée pour être utilisée dans la technique de mesure de champ proche.

20. Système de mesure selon l'une quelconque des revendications précédentes,
**caractérisé en ce que**
le dispositif de mesure (24) est un hélicoptère miniature.

21. Système de mesure selon l'une quelconque des revendications 1 à 19,
**caractérisé en ce que**
le dispositif de mesure (24) est un ballon.

22. Système de mesure selon l'une quelconque des revendications 1 à 19,
**caractérisé en ce que**
le dispositif de mesure (24) est un zeppelin.

23. Système de mesure selon l'une quelconque des revendications 1 à 19,
**caractérisé en ce que**
le dispositif de mesure (24) est un avion.

24. Procédé pour la caractérisation ultra précise de champs de rayonnement en utilisant un système de mesure selon l'une quelconque des revendications 1 à 23,
**caractérisé par**
a) l'arrangement flottant d'un dispositif de mesure (24) qui peut être télécommandé dans le champ de rayonnement, avec une tête de mesure (28) destinée à détecter le champ de rayonnement ainsi qu'au moins un dispositif (10) détectable par des dispositifs destinés à déterminer l'emplacement et la position, destiné à déterminer l'emplacement et la position du dispositif de mesure (24) ;
b) la détermination de l'emplacement et de la position du dispositif de mesure (24) ;
c) la génération d'un signal de mesure pour la caractérisation du champ de rayonnement ;
d) la transmission du signal de mesure de la partie flottante du système de mesure vers l'instrument de mesure au sol ;
e) la répétition multiple des étapes a) à d).

25. Procédé selon la revendication 24,
**caractérisé en ce que**
les coordonnés de chaque récepteur/antenne de position (10, 2) sont déterminées et qu'à partir de ces coordonnées, on détermine de manière dynamique l'emplacement réel et la position réelle dans les six degrés de liberté du dispositif de mesure notamment en temps réel.

26. Procédé selon la revendication 24 ou 25,
**caractérisé en ce que**
la position réelle et l'emplacement réel dans les six degrés de liberté du dispositif de mesure (24) sont comparés avec la position théorique et l'emplacement théorique, et que sur la base de cette comparaison, des indicateurs de réglage sont générés pour la commande du dispositif de mesure.
